# EUROPÄISCHE PATENTSCHRIFT

(11) **EP 4 174 277 B1**
(45) Veröffentlichungstag und Bekanntmachung des Hinweises auf die Patenterteilung: **11.06.2025**
(21) Anmeldenummer: 22201516.6
(22) Anmeldetag: 14.10.2022
(51) Int. Cl.: E06B 9/327, E06B 9/386, H02S 20/22

(54) **STROMABFÜHRUNGSSYSTEM FÜR EINE BESCHATTUNGSEINRICHTUNG UND BESCHATTUNGSEINRICHTUNG HIERFÜR**
CURRENT DISCHARGE SYSTEM FOR A SHADING DEVICE AND SHADING DEVICE THEREFOR
SYSTÈME D'ÉVACUATION DE COURANT POUR UN DISPOSITIF D'OMBRAGE ET DISPOSITIF D'OMBRAGE CORRESPONDANT

(30) Priorität: 26.10.2021 DE 102021127791
(43) Veröffentlichungstag der Anmeldung: 03.05.2023
(73) Patentinhaber: Solaregy GmbH, 40885 Ratingen (DE)
(72) Erfinder: Haid, Morris, 40885 Ratingen (DE); Legermann, Florian, 40885 Ratingen (DE)
(74) Vertreter: Dr. Binder & Binder GbR

(56) Entgegenhaltungen:
- EP-A1- 3 892 813
- CN-A- 110 107 207
- CN-B- 110 094 153
- CN-U- 202 047 738

## Beschreibung

Die Erfindung betrifft ein Stromabführungssystem mit Führungsbolzen und mindestens einer seitlichen Führungsschiene für eine Beschattungseinrichtung mit einer Vielzahl von Lamellen, wobei die Lamellen jeweils mittels der Führungsbolzen in der mindestens einen seitlichen Führungsschiene beweglich lagerbar sind und jeweils mindestens ein Photovoltaikelement zur Stromerzeugung aufweisen.

Weiter betrifft die Erfindung eine Beschattungseinrichtung mit einer Vielzahl von Lamellen, welche jeweils mittels Führungsbolzen in mindestens einer seitlichen Führungsschiene beweglich gelagert sind und jeweils mindestens ein Photovoltaikelement zur Stromerzeugung aufweisen.

Aus dem Stand der Technik sind Raffstoren mit Lamellen, auf denen Photovoltaikelemente (auch Photovoltaikzellen genannt) aufgebracht sind, bereits bekannt. Hierzu wird beispielsweise auf die Druckschriften DE 10 2007 031 236 A1 oder DE 10 2014 200 359 A1 verwiesen.

Weiterhin ist es aus der Druckschrift DE 21 2019 000 358 U1 bekannt, zur Stromabführung die Lamellen mittels eines Leiterdrahtes zu verbinden. Dieser Leiterdraht ist jedoch optisch unschön und wirkt sich nachteilig auf die Handhabung und Funktionalität des Raffstores aus.

Aus den Druckschriften EP 3690176 A1 und EP 3892813 A1 sind zudem gattungsgemäße Stromabführungssysteme bekannt, wobei hier keine Sammelschienen vorliegen, die über die gesamte Höhe der Beschattungseinrichtung verlaufen, sodass die elektrische Kontaktierung lediglich punktuell erfolgt. Weiterhin sind die Kontaktmittel lediglich als einfache Kontaktstifte ausgebildet.

Die Druckschrift CN 110107207 A zeigt noch eine Photovoltaik-Jalousie, bei der die Kontaktmittel als federgelagerte Stifte ausgebildet sind, wobei die Stifte lediglich in einer einfachen Hülse gelagert sind.

Als weiteren Stands der Technik wird noch auf die Druckschriften CN 202047738 U, CN 110 094 153 B verwiesen.

Es ist daher Aufgabe der Erfindung eine alternative Stromabführung für eine Beschattungseinrichtung mit Photovoltaiklamellen, insbesondere mit verbesserten Kontaktmitteln, sowie eine Beschattungseinrichtung hierfür bereitzustellen.

Diese Aufgabe wird durch die Merkmale der unabhängigen Patentansprüche gelöst. Vorteilhafte Weiterbildungen der Erfindung sind Gegenstand untergeordneter Ansprüche.

Die Erfinder haben erkannt, dass es eine alternative Möglichkeit gibt, die in den Photovoltaikelementen auf den beweglichen Lamellen eines Raffstores oder einer Jalousie erzeugte elektrische Energie an ein Stromnetz oder Stromspeicher abzuführen und die Nachteile des Standes Technik zu umgehen.

Die Erfindung beschreibt daher die Möglichkeit der Stromabführung über die Führungsschiene ohne eine aufwändige Verdrahtung der einzelnen Lamellen.

Die Elektrizitätsabführung kann durch Federkontakte an den Führungsbolzen der Lamellen und Sammelschienen in Form von Flachstangen in den Führungsschienen gewährleistet werden. Die Federkontakte bieten die Möglichkeit, Einbautoleranzen etc. auszugleichen. Ein Federkontakt weist einen Federkontaktstift (Kolben, Feder und Mantel) sowie eine Hülse auf, in die der Stift eingeschoben wird. Die Hülse erleichtert den Austausch bei einem Defekt des Federkontaktes. Die Hülse des Federkontaktes kann in den Führungsbolzen eingesetzt werden. Hierfür kann der Führungsbolzen entsprechend angepasst werden: Der Führungsbolzen kann durch eine Aussparung für die Hülse ergänzt werden, welche auf seiner in eingebauter Position horizontalen Drehachse liegt. Diese Position ist ideal für eine geringe mechanische Belastung auf den Federkontaktstift und den Führungsbolzen bei der Drehung der Lamelle und ermöglicht die Nutzung eines längeren Federkontaktes mit mehr Federweg, ohne weitere große Anpassungen am Führungsbolzen durchzuführen.

Die Flachstange stellt das Gegenstück zum Federkontakt dar. Es eignet sich vor allem eine Kupferflachstange. Eine Alternative zu Kupferflachstangen stellen Aluminiumflachstangen dar, welche allerdings eine schlechtere Leitfähigkeit aufweisen. Die Flachstange kann mittels Klebung oder Halteklips in dem Plastikeinsatz der Führungsschiene fixiert werden.

Die Verbindung der elektrischen Kontakte von den Photovoltaikelementen mit dem Federkontakt kann durch Verlötung des Photovoltaikelementes mit einer Lötkerbe am Ende der Federkontakthülse oder alternativ mittels eines in den Führungsbolzen integrierten Kupferleiters hergestellt werden. Der Kupferleiter endet mittig auf der Unterseite des Führungsbolzens und bietet dort eine Lötkontaktstelle für die Verbindung zu den sich auf der Lamelle befindlichen Photovoltaikelementen.

Auf das untere Ende der Kupferflachstange kann eine Isolationsschicht aufgetragen werden, damit auch bei Einbau auf einem Metallfensterbrett oder einer Wasserschicht auf der Unterlage keine Kurzschluss- oder Stromschlaggefahr besteht.

Dieses Konzept aus einem oder mehreren Federkontakt(en) in Kombination mit einer oder mehreren Flachstange(n) gewährleistet abhängig vom Hub des gewählten Federkontaktstiftes eine verschieden große Einbautoleranz hinsichtlich der Führungsschienen. Ein möglichst großer Hub ist durch die nicht zu vernachlässigende Längenänderung der Lamellen aufgrund thermischer Ausdehnung und Kontraktion besonders relevant. Um eine einheitliche Fertigung des Stromabführungssystems zu gewährleisten, kann der Hub der Federkontakte für eine maximale Wärmeausdehnung der maximal angebotenen Lamellengröße ausgelegt werden.

Um bei heraufgezogenen Lamellen eine Stapelung der Führungsbolzen weiterhin zu ermöglichen, kann der Kopf des Führungsbolzens um eine Aussparung an der Oberseite ergänzt werden. Die Breite der Aussparung korreliert sinnvollweise zur Breite des Federkontaktstiftes.

Eine sich durch die elektrischen Eigenschaften der ersten Generation von Photovoltaikelementen ergebene Problematik ist die zu geringe Spannung einer einzelnen Lamelle für marktübliche Wechselrichter. Um die Spannung zu erhöhen, sollte entweder ein angepasster Wechselrichter oder DC-Aufwärtswandler eingesetzt werden. Beide Varianten bringen jedoch zusätzliche Kosten sowie Leistungsverluste mit sich. Alternativ kann eine Parallelschaltung eingesetzt werden, bei der mindestens zwei Lamellenpakete parallelgeschaltet werden. Diese Parallelschaltung ist mit einem einzelnen Federkontakt pro Führungsbolzen allerdings nicht möglich.

Es können jedoch auch zwei Federkontakte pro Führungsbolzen ausgeführt werden.

Dadurch kann das Problem der zu geringen elektrischen Spannung der Photovoltaiklamellen gelöst werden. Weiterhin können dann zwei parallel verlaufende Kupferflachstangen in der Führungsschiene eingesetzt werden, die mittels eines (Plastik)-Isolators voneinander getrennt werden. Der Isolator erfüllt ebenso die Führungsaufgabe der Federkontaktstifte, welche genau wie bei der einfachen Ausführung in den Führungsbolzen versenkt werden können.

Die Kupferflachstangen können beispielsweise in den Plastikeinsatz eingeklebt oder mittels im Plastikeinsatz der Führungsschiene integrierter Halteklips fixiert werden.

Um ein Schleifen der versetzt laufenden Führungsbolzen an der Führungsschiene zu vermeiden, kann der Führungsbolzen erweiternd angepasst werden. Zum einen können die seitlichen Flanken des Führungsbolzens verschmälert werden. Zusätzlich kann der Öffnungsschlitz der Führungsschiene verbreitert werden. Die Aussparung für den Federkontakt des darüber liegenden Führungsbolzens im gestapelten Zustand kann zu jeweils beiden Seiten des Kopfes verschoben werden. Alternativ können die beiden oberen Flügel am Kopf des Führungsbolzens gänzlich entfernt werden. Zum anderen kann der Kopf des Führungsbolzens derart angepasst werden, dass er eine verbreiterte Form mit schräg verlaufenden Unter- und Oberkanten besitzt. Es kann ein Loch für jeweils einen Federkontakt im linken oberen sowie im rechten unteren Flügel eingefügt werden. Eine aktive Nutzung beider Federkontakte zur Elektrizitätsübertragung ist nicht zwingend notwendig, stellt allerdings eine Möglichkeit dar und dient der einfachen Serienherstellung. Die Drehung des Lamellenbehangs wird mit dieser Federkontaktausführung jedoch in der Regel auf 90° beschränkt. Je nach Form der Führungsschiene beziehungsweise Größe der Öffnung der Führungsschiene ist der Federkontakt beziehungsweise dessen Hub jedoch eingeschränkt.

Um die Flexibilität im Einbau eines Raffstores oder einer Jalousie mit Stromabführung zu erhöhen und Einbau- und Fertigungstoleranzen weiter auszugleichen, können auch herkömmliche Abstandshalter verwendet werden, mittels denen die Führungsschiene befestigt wird. Als Alternative zu der Verwendung von Abstandhaltern kann beispielsweise auch der Plastikeinsatz in den Führungsschienen oder die Flachstange in dem Plastikeinsatz variabel befestigt werden.

Die Enden beziehungsweise Köpfe der Federkontakte, welche den elektrischen Kontakt herstellen, können unterschiedliche Formen haben, beispielsweise rund, eckig oder plattenförmig. Bei einem plattenförmigen Kopf kann die Platte beziehungsweise der Kopf ebenfalls aus einem leitfähigen Material bestehen und an einem links und/oder rechts in der Führungsschiene befestigten, elektrischen Leiter, beispielsweise einer Flachstange, schleifen. Die Platten können entweder eckig oder rund ausgeführt werden. Eine eckige Platte wird sich jedoch nicht mit dem Federkontakt mitdrehen, sondern im ursprünglichen Rotationszustand verbleiben. Dann sollte der gesamte Federkontakt oder die Platte relativ zum Führungsbolzen drehbar sein.

Als Alternative zu Federkontakten können Schleifer als Kontaktmittel genutzt werden. Die Schleifer können an der Lamelle befestigt werden und an der Flachstange schleifen. Mögliche Arten eines Schleifers sind beispielsweise:
- Kupferlitze, vgl. "Carrerabahn"
- Schleifer mit Blattfeder, vgl. "Märklin"-Eisenbahn
- Bügelstromabnehmer
- Feder mit Schleifeinheit
- Grafit-Gleiter, vgl. Motor mit Gleitkontakt

Weiterhin können Gleitschuhe als elektrischer Kontakt zwischen Lamelle und Führungsschiene eingesetzt werden. Der Gleitschuh kann aus einem angepassten Führungsbolzen, einer Feder, einem Kupferschleifer und dem eigentlichen (Metall-)Gleitschuh aufgebaut sein. Der Führungsbolzen kann ebenfalls aus einem Metall gefertigt werden. Bei einer Metall- statt Plastikausführung wird kein innenliegender Leiter benötigt, da der Führungsbolzen selbst als Leiter fungiert.

Die Witterungsbeständigkeit des Stromabführungssystems ist durch den Einsatzort an einer Außenfassade wichtiger Bestandteil der Konstruktion. Um eine Langlebigkeit garantieren zu können, sollten externe Einflüsse wie Schmutz und Regen auf die Schleifelemente reduziert werden, um Verschmutzung oder Korrosion zu vermeiden. Neben beschleunigtem Verschleiß kann das Auftreten von Verschmutzungen beziehungsweise Korrosion eine Erhöhung des elektrischen Widerstandes der Leiter herbeiführen, was zu Leistungsverlusten führt.

Es können beispielsweise Bürstenleisten beziehungsweise -dichtungen in die Öffnungen der Führungsschienen eingesetzt werden, die die Öffnungen zumindest teilweise abdecken. Die Führungsbolzen können beim Auf- und Abfahren der Lamellen einfach durch die Bürsten bewegt werden. Die verwendeten Bürsten sollten vor allem wasserabweisend, stark biegsam, witterungs- und temperaturbeständig von idealerweise - 30°C bis +60°C sowie UV-beständig sein. Es eignen sich vor allem Bürsten aus Austauschstoffen wie unter anderem Polyamide, Polyvinylchloride, Polystrole, Polyester oder Polypropylene. Unter den Polyamiden sind Nylon und Perlon am bekanntesten geworden. Das Produkt Polyamid eignet sich zum Beispiel für Deckenbürsten, für verschiedene Pinsel oder Besen. Polyesterfasern sind sehr steif und nehmen kaum Wasser auf. Polypropylen wird unterhalb von 0°C spröde und ist, wenn ohne Weichmacher, umweltunbedenklich.

Ebenso können Gummidichtungen beziehungsweise -dichtlippen in die Öffnungen der Führungsschienen eingesetzt werden. Diese können etwas mehr Schmutz und Wasser abhalten und vor der Selbstverschmutzung schützen, wie dies beispielsweise bei spröde werdenden Bürsten der Fall ist. Die Gummidichtungen können ebenfalls beidseitig der Öffnungen angebracht werden und dehnen sich, wenn ein Führungsbolzen in der Mitte der beiden Dichtungen hoch- oder runterfährt. Die verwendeten Gummidichtungen sollten vor allem wasserabweisend, dauerhaft biegsam, witterungsbeständig, insbesondere UV-beständig, sowie temperaturbeständig von idealerweise -30°C bis +60°C sein und einen möglichst geringen Haftreibungskoeffizienten haben. Es eignen sich vor allem Gummidichtungen aus Silikon-Kautschuk aufgrund dessen dauerhafter Elastizität bei geringem Druckverformungsrest (absolut sprungelastisch), hoher Alterungsbeständigkeit, sehr hoher UV- und Temperaturbeständigkeit sowie voller Beständigkeit gegen wasserverdünnbare und konventionelle Anstriche.

Weiterhin können zwischen den Führungsbolzen benachbarter Lamellen auch flexible Stoffbahnen angebracht werden, die im heruntergefahrenen Zustand des Raffstores beziehungsweise der Jalousie die Öffnungen der Führungsschienen zumindest teilweise abdecken. Der verwendete Stoff sollte vor allem wasserabweisend, biegsam, witterungs- und temperaturbeständig von idealerweise -30°C bis +60°C, insbesondere UV-beständig, sowie reißfest und möglichst atmungsaktiv sein.

Auf den Lamellen können unterschiedliche Photovoltaikelemente verwendet werden. Die verschiedenen Konzepte zu den Photovoltaiklamellen lassen sich nach den verschiedenen Techniken der verwendeten Photovoltaikelemente gliedern. Photovoltaikelemente der ersten Generation (waferbasierte Photovoltaikelemente) und Photovoltaikelemente der zweiten Generation zeichnen sich dadurch aus, dass sie nicht die Shockley-Queisser (SQ)-Grenze für Einzel-Bandabschnitt-Geräte überschreiten. Photovoltaikelemente der dritten Generation weisen hingegen ein Wirkungsgradpotenzial oberhalb der SQ-Grenze auf. Durch die SQ-Grenze wird der maximal erreichbare Umwandlungswirkungsgrad der Sonnenenergie für ein bestimmtes Material beschrieben. Die Grenze ist der Maßstab, an dem neue Photovoltaik-Technologien verglichen werden. Ein bestimmtes Material hat eine bestimmte Bandlücke, die dafür verantwortlich ist, dass nur bestimmte Spektren des Lichts absorbiert werden können. Die restlichen Spektren können so nicht absorbiert und damit auch nicht zur Umwandlung in elektrischen Strom genutzt werden (Photovoltaikelemente der ersten und zweiten Generation). Photovoltaikelemente der dritten Generation umgehen diese Tatsache beispielsweise durch sogenannte Tandemphotovoltaikelemente, bei denen mehrere Materialien in verschiedenen Schichten verwendet werden, um die restlichen Spektren des Lichts ebenfalls absorbieren und in elektrischen Strom umwandeln zu können.

Konventionelle Photovoltaikelemente der ersten Generation:
Hier kommen Photovoltaikelemente der ersten Generation, also waferbasierte Photovoltaikelemente, zum Einsatz. Diese Technologie ist vorteilhaft, da sie bedingt durch langjährige Erforschung und ihren großen Marktanteil ein besonders hohes Maß an Langzeiterprobung und ein sehr gutes Preis-Leistungsverhältnis sowie eine sehr hohe Effizienz aufweist. Wesentlicher Nachteil ist jedoch, dass massengefertigte Photovoltaikmodule dieser Technologie nur in Größen erhältlich sind, die nicht auf die Lamellen aufzubringen sind. Daher müssen mit konventionellen Photovoltaikelementen bestückte Lamellen so hergestellt werden, dass die Photovoltaikelemente auf den Rohlamellen selbst zu einem Modul verschaltet und laminiert werden. Da einzelne Standardphotovoltaikelemente zu groß für die Lamellen sind, müssen diese durchgeschnitten werden.

Photovoltaikelemente der zweiten und dritten Generation:
Diese Photovoltaikelemente bringen den Vorteil mit sich, dass sie teilweise bedingt durch andere Herstellungsverfahren mit deutlich weniger Modifikationen des Herstellungsprozesses in nahezu beliebigen Größen hergestellt werden können. Dadurch kann die vorhandene Oberfläche der Lamelle ohne Freiräume und damit effizienter genutzt werden. Ein entscheidender Nachteil ist hingegen, dass Photovoltaikelemente der zweiten und dritten Generation nach dem aktuellen Stand der Technik bezüglich ihrer Effizienz häufig noch nicht mit den Photovoltaikelemente der ersten Generation konkurrieren können. Einige Herstellungsprozesse erlauben es, die als Dünnschicht ausgeprägte Photovoltaikzellenschicht direkt auf den Lamellen, die damit als Substrat fungieren, aufzudampfen. Dafür ist es eventuell förderlich, die Lamellen im Vorhinein zu beschichten, sodass diese geeignetere Eigenschaften für ihre Rolle als Substrat aufweisen. Zu den während des Herstellprozesses eingesetzten Verfahren gehören das thermische Verdampfen, die Sputterdeposition, die Laserdeposition und die Metallorganische Gasphasenepitaxie.

Klebende Photovoltaikelemente der zweiten und dritten Generation:
Hier werden ebenfalls Photovoltaikelemente der zweiten und dritten Generation verwendet, die allerdings nicht auf der Lamelle selbst, sondern auf einer Folie hergestellt und anschließend auf die Lamellen aufgeklebt werden. Dieses Konzept bringt den entscheidenden Vorteil mit sich, dass eine räumliche Trennung zwischen der Produktion der Lamellen und der Produktion der Photovoltaikelemente möglich ist. Die Photovoltaikfolie kann als Meterware hergestellt und in der korrekten Breite vorgelagert und passend zugeschnitten werden.

Zudem können auch unterschiedliche Lamellen verwendet werden. Durch die Verwendung von im Aufbringungsbereich der Photovoltaikelemente weniger gebogenen Lamellen, beispielsweise Flachlamellen, können sich positive Effekte ergeben. Zum einen müssen sich die Photovoltaikelemente nur an eine weniger stark ausgeprägte Biegung anpassen, was den Produktionsprozess erleichtert sowie die Anforderungen an die Photovoltaikelemente selbst herabsetzt. Zum anderen können die Photovoltaikelemente einfacher vor äußeren Einflüssen geschützt werden. Entscheidend ist es, dass die Verkapselung der Photovoltaikzellenschicht an den Rändern der Lamellen ausreichend stark und zuverlässig anhaftet, damit sie ihre verkapselnde Wirkung entfalten kann. Da es durch Ausdehnung beziehungsweise Kontraktion der Lamellen zu Ablösungen an Schwachstellen, wie den Rändern, kommen kann, bietet es sich an, hier gesonderte Vorkehrungen zu treffen. Beispielsweise kann die Verkapselung um eine oder mehrere äußere Kanten der Lamellen umgeschlagen werden, sodass die Folie ebenfalls auf der Unterseite der Lamelle anhaften kann. Da die Flachlamelle über keine Bördelung an den äußeren Kanten verfügt, ist das Umschlagen der Folie ohne Probleme möglich. Bei einer randgebördelten Lamelle würde sich die Folie nicht ohne Probleme umschlagen und laminieren lassen und die Pakethöhe würde weiter steigen, da die Folie über die Bördelung reichen und somit die dickste Stelle der Lamelle weiter verdicken würde. An der Unterseite kann die Folie dann durch weitere, mögliche Verfahren wie zum Beispiel Kleben besonders stark befestigt werden.

Um die Spannung bei der Abführung des in den Photovoltaikelemente erzeugten Stromes zu erhöhen und Verluste bei der Umwandlung auszugleichen, ist es möglich, mehrere Lamellen auf unterschiedliche Art und Weise seriell miteinander zu verschalten.

Demgemäß schlagen die Erfinder vor, ein Stromabführungssystem mit Führungsbolzen und mindestens einer seitlichen Führungsschiene für eine Beschattungseinrichtung mit einer Vielzahl von Lamellen, insbesondere für einen Raffstore oder für eine Jalousie, wobei die Lamellen jeweils mittels der Führungsbolzen in der mindestens einen seitlichen Führungsschiene beweglich lagerbar sind, wobei die Beschattungseinrichtung Photovoltaikelemente zur Stromerzeugung aufweist, wobei die Photovoltaikelemente mit den Führungsbolzen der jeweiligen Lamelle elektrisch verbindbar sind, wobei in der mindestens einen Führungsschiene insgesamt mindestens zwei elektrische Sammelschienen vorliegen, sodass ein elektrischer Kontakt durch mindestens ein Kontaktmittel mit den Photovoltaikelementen der Lamellen herstellbar ist, um den erzeugten Strom abzuführen, dahingehend zu verbessern, aufweisen, von welchem das mindestens eine Kontaktmittel in Längsrichtung der Lamelle absteht, wobei das Kopfteil zumindest an seiner Oberseite eine Aussparung aufweist, um im hochgezogenen Zustand der Beschattungseinrichtung ein platzsparendes Stapeln der Lamellen zu ermöglichen, und die Kontaktmittel als Federkontaktstift ausgebildet sind, wobei der Federkontaktstift zumindest einen Kolben, eine Hülse und eine innenliegende Feder aufweist, und die Hülse in den Führungsbolzen integriert ist, sodass der Führungsbolzen als Hülse und Führung für den Kolben dient.

Das erfindungsgemäße Stromabführungssystem dient dazu, den in den Photovoltaikelementen der Lamellen erzeugten Strom in ein Stromnetz oder einen Stromspeicher einzuspeisen. Je nach Ausführung des Stromabführungssystems ist vorteilhafterweise zusätzlich noch ein Wechselrichter vorgesehen. Bei der Beschattungseinrichtung handelt es sich bevorzugt um einen Raffstore oder eine Jalousie, insbesondere eine Jalousienüberdachung. Im Folgenden wird die Erfindung an einer als Raffstore ausgebildeten Beschattungseinrichtung beschrieben.

Gemäß einer bevorzugten Ausführungsform sind zwei seitliche Führungsschienen ausgebildet, in denen die Führungsbolzen beweglich gelagert sind. Dementsprechend liegen in den beiden Führungsschienen insgesamt mindestens zwei elektrische Sammelschienen vor. Im Folgenden wird die Erfindung für eine Ausführungsform mit zwei seitlich angebrachten Führungsschienen beschrieben. Eine Ausführungsform mit nur einer Führungsschiene liegt jedoch ebenso im Rahmen der Erfindung.

Die Lamellen des Raffstores sind wie bei herkömmlichen Raffstoren mittels der an den kurzen Längsenden angebrachten Führungsbolzen in den seitlichen Führungsschienen beweglich gelagert. Beim Hoch- und Runterfahren der Lamellen bewegen sich die Führungsbolzen in den Führungsschienen.

Die Photovoltaikelemente der Lamellen sind elektrisch mit den Führungsbolzen verbunden, beispielsweise mittels einer Löt- oder Kupferleitung. Eine Ausführungsform des Stromabführungssystems sieht daher vor, dass das mindestens eine Photovoltaikelement einer Lamelle mit dem mindestens einen Kontaktmittel elektrisch verbunden ist, beispielsweise über eine Lötverbindung oder eine Kabelverbindung.

Erfindungsgemäß liegen in den beiden Führungsschienen eines Raffstores beziehungsweise eines Lamellenpaketes insgesamt mindestens zwei elektrische Sammelschienen vor. Die mit den Photovoltaikelementen elektrisch verbundenen, bewegbaren Führungsbolzen kontaktieren die positionsfesten Sammelschienen, sodass der erzeugte Strom in das Stromnetz oder in einen Stromspeicher abgeführt wird. Es entsteht vorzugsweise ein Schleifkontakt zwischen Führungsbolzen und Sammelschiene. Jede Lamelle weist mindestens zwei Kontaktmittel auf, also an jedem Längsende mindestens ein Kontaktmittel, das heißt in Summe pro Lamelle mindestens zwei. Vorteilhafterweise sind die Längsenden der Lamellen bezüglich der Anzahl, Anordnung und Ausführung der Kontaktmittel gleich ausgebildet. Die Kontaktmittel sind an den Führungsbolzen der Lamellen angebracht. Somit weist vorteilhafterweise ein Führungsbolzen mindestens ein Kontaktmittel auf, welches den elektrischen Kontakt zur Sammelschiene ausbildet. Die Kontaktmittel sind vorteilhafterweise federnd oder zumindest teilweise bewegbar gelagert, um mögliche Einbau- oder Fertigungstoleranzen etc. des Raffstores auszugleichen.

Jede Lamelle steht mit zwei unterschiedlich gepolten Sammelschienen in Kontakt. Hierfür gibt es verschiedene Ausführungsformen hinsichtlich der Anzahl der Kontaktmittel und/oder der Sammelschienen sowie deren Ausführung. Beispielsweise kann ein Führungsbolzen ein oder zwei Kontaktmittel aufweisen und in einer Führungsschiene können eine oder zwei Sammelschienen angeordnet sein.

Eine einfache Ausführungsform sieht vor, dass ein Führungsbolzen genau ein Kontaktmittel aufweist. Das Kontaktmittel ist bevorzugt in Verlängerung der Längsachse der Lamelle an dem Führungsbolzen ausgebildet.

Dabei können die jeweils einen Kontaktmittel benachbarter Lamellen an den Führungsbolzen senkrecht untereinander angeordnet sein.

Alternativ können die jeweils einen Kontaktmittel benachbarter Lamellen an den Führungsbolzen seitlich versetzt untereinander angeordnet sein.

Eine andere Ausführungsform sieht vor, dass ein Führungsbolzen zwei Kontaktmittel aufweist. Die Kontaktmittel sind bevorzugt parallel zur Verlängerung der Längsachse der Lamelle an dem Führungsbolzen ausgebildet.

Vorteilhafterweise sind bei dieser Ausführung mit zwei Kontaktmitteln pro Führungsbolzen die Kontaktmittel schräg versetzt angeordnet. Das heißt, dass die zwei Kontaktmittel an einem Führungsbolzen relativ zu einer durch die Oberfläche der Lamellen verlaufenden Ebene auf unterschiedlicher Höhe seitlich versetzt angeordnet sind.

Weitere Varianten und Kombinationen der Kontaktmittel, Führungsbolzen etc. sind ebenfalls möglich und liegen im Rahmen der Erfindung.

Eine ebenfalls einfache Ausführungsform sieht genau eine Sammelschiene pro Führungsschiene vor. Bevorzugt ist die eine Sammelschiene gegenüber der Längsöffnung in der Führungsschiene angeordnet.

Eine andere Ausführungsform sieht zwei Sammelschienen in einer Führungsschiene vor. Bevorzugt sind die zwei Sammelschienen entweder nebeneinander gegenüberliegend zur Längsöffnung oder auf beiden Seiten der Längsöffnung in der Führungsschiene angeordnet.

In die Führungsschienen ist bevorzugt jeweils ein zusätzlicher Einsatz vorhanden, in dem die Sammelschiene(n) befestigt ist beziehungsweise sind, beispielsweise eingeklebt und/oder eingeklipst. Der Einsatz ist vorzugsweise aus einem nicht-leitenden und isolierenden Material wie Kunststoff, Plastik oder dergleichen ausgebildet. Zur Befestigung der Sammelschienen in dem Einsatz weist dieser bevorzugt Haltenasen auf, die sich zumindest über einen Teil der Länge des Einsatzes beziehungsweise der Sammelschiene erstrecken. Vorteilhafterweise sind die Haltenasen jeweils paarweise gegenüberliegend oder versetzt gegenüberliegend angeordnet, sodass die Führungsschiene zwischen die Haltenasen eingeklipst werden kann.

Die Einsätze sind vorzugsweise einteilig ausgebildet und mittels eines Strangpressbeziehungsweise Extrusionsverfahrens hergestellt.

Bei einer Ausführungsform mit zwei nebeneinander positionierten Sammelschienen dient der Einsatz gleichzeitig auch als Isolation zwischen den beiden Sammelschienen, indem der Einsatz bevorzugt eine Isolation zwischen zwei nebeneinander angeordneten Sammelschienen ausbildet. Dieser Isolator kann beispielsweise als eine Art Abstandhalter zwischen den beiden Sammelschienen ausgebildet sein.

Erfindungsgemäß weisen die Führungsbolzen jeweils ein scheibenartiges Kopfteil auf, von welchem das mindestens eine Kontaktmittel in Längsrichtung der Lamelle absteht. Dabei sind weiterhin erfindungsgemäß die Kopfteile benachbarter Lamellen derart geformt, dass die Kopfteile im hochgezogenen Zustand des Raffstores möglichst platzsparend gestapelt werden können.

Die Sammelschienen sind grundsätzlich aus einem möglichst gut leitfähigen Material ausgebildet. Hierfür eignet sich in einer bevorzugten Ausführungsform ein Metall oder eine Legierung, beispielsweise (aus) Kupfer oder Aluminium. Weiterhin bevorzugt sind die Sammelschienen als Flachband oder Flachstange ausgebildet. Vorteilhafterweise reicht eine Sammelschiene über die gesamte Höhe einer Führungsschiene.

Als alternative Ausführungsform können die Sammelschienen als elektrisch leitende Bürste ausgebildet sein.

Weiterhin ist es günstig, wenn zumindest ein unteres Ende der Sammelschienen isoliert ist, um einen Kurzschluss beim Einbau in ein Metallfensterbrett oder bei Regen etc. zu vermeiden.

Die Kontaktmittel an den Führungsbolzen können unterschiedlich ausgeführt sein. Erfindungsgemäß sind die Kontaktmittel als Federkontaktstift ausgebildet, beispielsweise mit rundem, eckigem oder plattenförmigem Kolbenkopf. Weitere mögliche Ausführungsformen der Kontaktmittel sind entsprechend der nachfolgenden Liste wie folgt: Kupferlitze, Schleifer mit Blattfedern, Bügelstromabnehmer, Feder mit Schleifeinheit, Grafit-Gleiter oder Gleitschuh. Alle Ausführungsformen der Kontaktmittel sind vorzugsweise federnd oder zumindest teilweise bewegbar gelagert.

Die erfindungsgemäße Ausführungsform eines Kontaktmittels ist ein Federkontaktstift. Vorteilhafterweise eignet sich hierfür ein besonders gut leitendes Material wie Kupfer oder Aluminium. Der Federkontaktstift umfasst einen Kolben mit einem runden, eckigen oder plattenartigen Kopf sowie eine(n) Hülse beziehungsweise Mantel und eine innenliegende Feder. Die Hülse ist in den Führungsbolzen integriert, sodass der Führungsbolzen als Hülse und Führung für den Kolben dient. Der Kopf des Kolbens steht in Kontakt mit der Kontaktschiene und bildet die elektrische Verbindung zur Stromabführung aus.

Für einen plattenartigen Kolbenkopf beziehungsweise eine plattenartige Ausformung am Ende des Kolbens eignet sich eine runde oder eckige Platte. Die Platte kann beispielsweise jeweils eine Sammelschiene auf einer Seite der Längsöffnung der Führungsschiene kontaktieren. Nachteilhaft an eckigen Platten ist, dass diese sich bei einer Drehung der Lamelle nicht mit dem Federkontaktstift mitdrehen. Dies kann jedoch umgangen werden, indem das gesamte Kontaktmittel mit dem Führungsbolzen relativ zur Lamelle drehbar ist.

Weiterhin ist das erfindungsgemäße Stromabführungssystem vorteilhafterweise vor Witterungseinflüssen wie Regen, Sonneneinstrahlung etc. geschützt, um eine möglichst hohe Lebensdauer bei geringem Verschleiß zu gewährleisten.

Eine Ausführungsform des Stromabführungssystems sieht daher vor, dass in die Längsöffnungen der Führungsschienen zumindest abschnittsweise Gummidichtungen und/oder Bürstendichtungen eingesetzt sind. Diese Dichtungen verschließen die Längsöffnung nicht komplett, sondern erlauben ein Hoch- und Runtergleiten der Führungsbolzen durch die Dichtungen.

Vorteilhaft an Bürstendichtungen, beispielsweise aus Nylon oder Perlon, ist:
- die einfache Umsetzbarkeit durch vorgefertigte Leisten, die entlang der Längsöffnungen aufgebracht werden können;
- Bürstendichtungen sind witterungs- und wasserbeständig;
- der Austausch von Lamellen wird dadurch nicht beeinflusst; und
- Schutz in allen Positionen der Lamellen.

Allerdings können sich einzelne Borsten lösen und somit die Sammelschienen verschmutzen. Eine Bürstendichtung bietet zudem keinen vollständigen Schutz gegen das Eindringen von Feuchtigkeit und Staub.

Vorteilhaft an Gummidichtungen, beispielsweise aus einem Silikon-Kautschuk, ist:
- Schutz vor Spritzwasser und Schmutz;
- leichte Installation;
- der Austausch von Lamellen wird dadurch nicht beeinflusst;
- Schutz in allen Positionen der Lamellen

Allerdings bestehen hohe Anforderungen an das Material der Gummidichtungen, da diese dauerhaft elastisch sein und nicht spröde werden sollten. Die Reibung der Führungsbolzen an der Dichtung ist bei einer Gummidichtung deutlich größer als bei einer Bürstendichtung.

Eine andere Ausführungsform des Stromabführungssystems sieht vor, dass zwischen den Führungsbolzen benachbarter Lamellen jeweils ein Stoffeinsatz angeordnet ist, welcher im heruntergelassenen Zustand der Lamellen aufgespannt wird und die Öffnungen der Führungsschienen zumindest teilweise abdeckt. Der verwendete Stoff ist vorteilhafterweise möglichst flexibel, witterungsbeständig und atmungsaktiv sowie wasser- und UV-dicht.

Vorteilhaft an Stoffeinsätzen ist:
- die Längsöffnungen werden staub- und wasserdicht abgedeckt;
- Installation schon mit mittlerem Aufwand möglich; und
- eingedrungene Feuchtigkeit kann wieder verdunsten.

Allerdings schützt ein Stoffeinsatz die Längsöffnung nur im heruntergefahrenen Zustand der Lamellen. Die einzelnen Stoffbereiche können materialabhängig an den Seiten ausfransen. Der Austausch einzelner Lamellen wird durch die an den Lamellen befestigten Stoffeinsätze erschwert.

In einer vorteilhaften Ausführung des erfindungsgemäßen Stromabführungssystems einer Beschattungseinrichtung mit einer Vielzahl von Lamellen mit Photovoltaikelementen wird vorgeschlagen, dass mehrfach jeweils mindestens zwei Lamellen untereinander seriell elektrisch zu jeweils einem Lamellensatz verbunden sind, wobei die Verbindungsstellen zwischen den zwei Lamellen eines Lamellensatzes untereinander parallel über jeweils eine Sammelschiene elektrisch gekoppelt sind.

Werden in der Beschattungseinrichtung mehrere Lamellensätze verwendet, die aus jeweils zwei seriell verbundenen Lamellen bestehen, so kann dies verwirklicht werden, indem je Lamellensatz genau zwei seriell geschaltete Lamellen vorliegen, wobei:
- die potentialgleichen Verbindungsstellen zwischen der jeweils ersten Lamelle und der zweiten Lamelle eines Lamellensatzes über eine Sammelschiene auf einer ersten Seite der Beschattungseinrichtung elektrisch verbunden sind, und
- jeder Lamellensatz an je eine positive und eine negative Sammelschiene auf der zur ersten Seite gegenüberliegenden zweiten Seite der Beschattungseinrichtung elektrisch angeschlossen ist. Hieraus ergibt sich dann, dass die Lamellen bezüglich ihrer Polarität von oben nach unten alternierend angeordnet sind.

Werden in der Beschattungseinrichtung mehrere Lamellensätze verwendet, die aus jeweils drei seriell untereinander verbundenen Lamellen bestehen, so kann dies verwirklicht werden, indem ein Stromabführungssystem so gestaltet ist, dass je Lamellensatz genau drei seriell geschaltete Lamellen vorliegen, wobei:
- die potentialgleichen Verbindungsstellen zwischen den jeweils ersten Lamellen und den zweiten Lamellen über eine erste Sammelschiene auf einer ersten Seite der Beschattungseinrichtung elektrisch verbunden sind,
- die potentialgleichen Verbindungsstellen zwischen den jeweils zweiten Lamellen und den dritten Lamellen über eine zweite Sammelschiene auf einer zweiten - der ersten Seite gegenüberliegenden - Seite der Beschattungseinrichtung elektrisch verbunden sind, und
- jeder Lamellensatz an eine positive Sammelschiene und eine negative Sammelschiene auf jeweils einer Seite der Beschattungseinrichtung elektrisch angeschlossen ist.

Die Erfindung betrifft noch eine Beschattungseinrichtung, insbesondere einen Raffstore oder eine Jalousie, zumindest aufweisend einen Behang mit einer Vielzahl von Lamellen, welche jeweils mittels Führungsbolzen in mindestens einer seitlichen Führungsschiene beweglich gelagert sind und jeweils mindestens ein Photovoltaikelement zur Stromerzeugung aufweisen, wobei zur Abführung des erzeugten Stromes ein voranstehend beschriebenes, erfindungsgemäßes Stromabführungssystem vorliegt.

Bei der Beschattungseinrichtung handelt es sich bevorzugt um einen Raffstore oder eine Jalousie, insbesondere eine Jalousienüberdachung. Die Erfindung wird weiterhin an einer als Raffstore ausgebildeten Beschattungseinrichtung beschrieben.

Der Aufbau des Raffstores entspricht dem Aufbau eines herkömmlichen Raffstores. Auf den Lamellen sind Photovoltaikelemente zur Stromerzeugung angebracht, beispielsweise als komplette Beschichtung der Lamellen oder einzelne Bereiche auf den Lamellen. Es können sowohl konventionelle Photovoltaikelemente der ersten Generation also auch Photovoltaikelemente der zweiten oder dritten Generation eingesetzt werden.

Eine Ausführungsform der Beschattungseinrichtung, insbesondere eines Raffstores, sieht vor, dass der Behang zumindest ein erstes Lamellenpaket und ein zweites Lamellenpaket umfasst, wobei die Lamellenpakete unterschiedlich um die jeweiligen Längsachsen der Lamellen gekippt sind. Bei dieser Art von Behang spricht man allgemein auch von einem zweigeteilten Behang. Vorzugsweise ist ein oberes Lamellenpaket separat von den restlichen Lamellen rotierbar beziehungsweise kippbar. Beispielsweise kann ein unterer Bereich des Behanges zur Stromerzeugung komplett geschlossen sein, während ein oberer Bereich weiterhin offen oder zumindest teilweise offen ist, um Tageslicht in einen Raum eindringen zu lassen.

Im Folgenden wird die Erfindung anhand der bevorzugten Ausführungsbeispiele mit Hilfe der Figuren näher beschrieben, wobei nur die zum Verständnis der Erfindung notwendigen Merkmale dargestellt sind beziehungsweise beschrieben werden.

Es zeigen im Einzelnen:
- FIG 1:: eine schematische Querschnittsansicht entlang der Längsachse eines Führungsbolzens in einer ersten Ausführungsform,
- FIG 2:: eine schematische Draufsicht des Führungsbolzens gemäß der Figur 1,
- FIG 3:: eine schematische Querschnittsansicht senkrecht zur Längsachse des Führungsbolzens durch das Kopfteil gemäß der Figur 1,
- FIG 4:: eine schematische Perspektivansicht des Führungsbolzens gemäß der Figur 1,
- FIG 5:: eine schematische Querschnittsansicht einer Führungsschiene mit dem Führungsbolzen gemäß der Figur 1 zur Stromabführung,
- FIG 6:: eine schematische Querschnittsansicht entlang der Längsachse eines Führungsbolzens in einer zweiten Ausführungsform,
- FIG 7:: eine schematische Draufsicht des Führungsbolzens gemäß der Figur 6,
- FIG 8:: eine schematische Perspektivansicht des Führungsbolzens gemäß der Figur 6,
- FIG 9:: eine schematische Querschnittsansicht senkrecht zur Längsachse des Führungsbolzens gemäß der Figur 5,
- FIG 10:: eine schematische Querschnittsansicht eines Einsatzes für eine Führungsschiene mit zwei Führungsbolzen gemäß der Figur 6 zur Stromabführung,
- FIG 11:: eine schematische Querschnittsansicht entlang der Längsachse eines Führungsbolzens in einer dritten Ausführungsform,
- FIG 12:: eine schematische Draufsicht des Führungsbolzens gemäß der Figur 11,
- FIG 13:: eine schematische Perspektivansicht des Führungsbolzens gemäß der Figur 11,
- FIG 14:: eine schematische Querschnittsansicht senkrecht zur Längsachse des Führungsbolzens gemäß der Figur 11,
- FIG 15:: eine schematische Querschnittsansicht eines Einsatzes für eine Führungsschiene mit zwei Führungsbolzen gemäß der Figur 11 zur Stromabführung,
- FIG 16:: eine schematische Darstellung eines Raffstores mit Stromabführungssystem und einer ersten Reihenschaltung der Lamellen,
- FIG 17:: schematisch vereinfachte Darstellung der elektrischen Serienschaltung des Raffstores gemäß Figur 16,
- FIG 18:: eine schematische Darstellung eines Raffstores mit Stromabführungssystem und einer weiteren Reihenschaltung der Lamellen, und
- FIG 19:: schematisch vereinfachte Darstellung der elektrischen Serienschaltung des Raffstores gemäß der Figur 17.

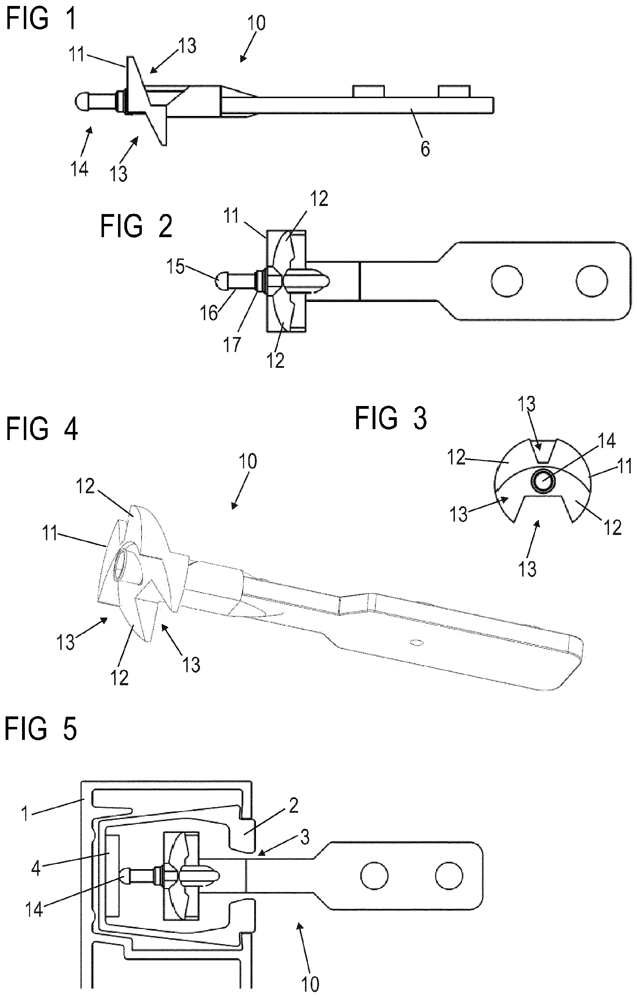

Die **Figur 1** zeigt eine schematische Querschnittsansicht entlang der Längsachse eines Führungsbolzens 10 in einer ersten Ausführungsform. Der Führungsbolzen 10 ist an einem Ende im rechten Bildbereich mit einem Zwischenstück 6 verbunden, an welches die Lamelle angebracht wird. Am anderen Ende des Führungsbolzens 10 weist dieser ein Kopfteil 11 auf, welches im montierten Zustand in der Führungsschiene angeordnet ist, siehe Figur 5. Aus dem Kopfteil 11 ragt in Längsrichtung des Führungsbolzens 10 und in Verlängerung der Längsachse ein Federkontaktstift 14 hervor, welcher im montierten Zustand den elektrischen Kontakt zwischen den Photovoltaikelementen auf der Lamelle und der Sammelschiene herstellt, siehe Figur 5. Die Photovoltaikelemente der Lamelle, hier nicht dargestellt, sind mittels einer internen Kupferleitung mit dem Federkontaktstift 14 elektrisch verbunden.

Der Federkontaktstift 14 umfasst einen Kolben 16 mit einem runden Kolbenkopf 15 und eine Hülse 17 sowie eine innenliegende Feder. Die Hülse 17 ist größtenteils innerhalb des Kopfteils 11 angeordnet. Weiterhin ist der Federkontaktstift 14 aus Kupfer ausgebildet, welches eine gute elektrische Leitfähigkeit aufweist.

In dieser Ausführungsform weist das Kopfteil 11 eine rechteckige Grundform auf, wie in der schematischen Draufsicht des Führungsbolzens 10 in der **Figur 2** zu sehen ist. Das Kopfteil 11 weist sowohl an der Unter- und Oberseite als auch links und rechts Aussparungen 13 auf, welche halbrunde Flügel 12 ausformen. In der Querschnittsansicht senkrecht zur Längsachse des Führungsbolzens 10 in der **Figur 3** ist vor allem die halbrunde Form der beiden Flügel 12 des Kopfteils 11 sowie die eine obere und untere Aussparung 13 zu erkennen. Die beiden Aussparungen 13 dienen vor allem dazu, dass die Lamellen im hochgezogenen Zustand zu einem möglichst kompakten und platzsparenden Paket zusammengeschoben werden können, wobei jeweils die Führungsbolzen 10 benachbarter Lamellen in der oberen beziehungsweise unteren Aussparung 13 positioniert sind.

In der **Figur 4** ist noch eine schematische Perspektivansicht des Führungsbolzens 10 gemäß der Figur 1 gezeigt, jedoch ohne Federkontaktstift, wobei vor allem die Form des Kopfteils 11 mit den durch die Aussparungen 13 ausgeformten Flügeln 12 zu erkennen ist. Beim Stapeln werden die unteren Bereiche der Flügel 12 einer oberen Lamelle in den oberen Aussparungen 13 einer unteren Lamelle positioniert und die oberen Bereiche der Flügel 12 der oberen Lamelle werden wiederum in den unteren Aussparungen 13 einer nächst-oberen Lamelle positioniert usw.

Die **Figur 5** zeigt eine schematische Querschnittsansicht einer Führungsschiene 1 eines nicht weiter dargestellten Raffstores mit dem Führungsbolzen 10 gemäß der Figur 1 zur Stromabführung. In die Führungsschiene 1 ist ein zusätzlicher Einsatz 2 aus einem Kunststoff eingebracht, welcher die Längsöffnung 3 der Führungsschiene 1 verschmälert und für eine bessere Führung des Führungsbolzens 10 sorgt. Der Führungsbolzen 10 ragt durch die Längsöffnung 3 in die Führungsschiene 1 hinein, sodass das Kopfteil 11 innerhalb der Führungsschiene 1 angeordnet ist.

Gegenüber der Längsöffnung 3 ist in dieser Ausführungsform genau eine Sammelschiene 4 angeordnet, welche sich in Längsrichtung der Führungsschiene 1 erstreckt. Die Sammelschiene 4 ist einteilig als eine Flachstange aus Kupfer ausgebildet. Zur Befestigung in dem Einsatz 2 ist die Flachstange eingeklebt.

Der runde Kolbenkopf 15 des Federkontaktstiftes 14 stößt an die Flachstange an und bewegt sich beim Hoch- und Runterfahren der Lamellen entlang der Flachstange. Mögliche Fertigungstoleranzen oder temperaturbedingte Längenänderungen der Bauteile werden durch den Hub des federgelagerten Kolbenkopfes 15 ausgeglichen.

Der in den Photovoltaikelementen der Lamellen erzeugte Strom wird über eine Kupferdrahtleitung in den Federkontaktstift 14 und weiter über die Flachstange abgeführt. Das Stromabführungssystem ist ggf. über einen Wechselrichter an ein Stromnetz oder an einen Stromspeicher angeschlossen.

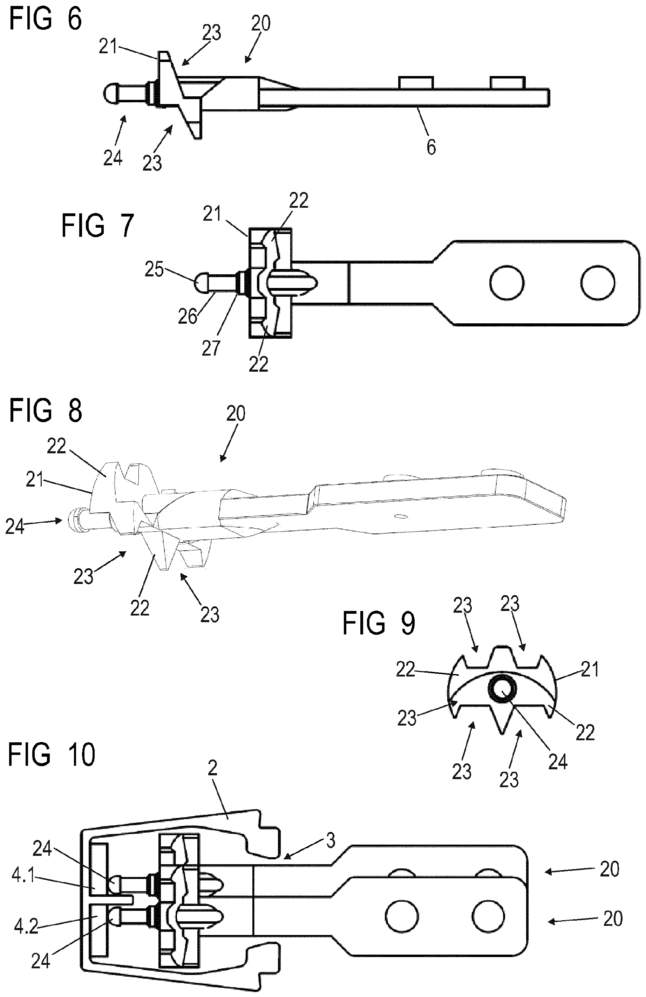

Die **Figur 6** zeigt eine schematische Querschnittsansicht entlang der Längsachse eines Führungsbolzens 20 und die **Figur 7** eine schematische Draufsicht des Führungsbolzens 20 in einer zweiten Ausführungsform. Der Führungsbolzen 20 gemäß den Figuren 6 und 7 unterscheidet sich lediglich in der Ausbildung des Kopfteils 21 von dem Führungsbolzen 10 der Figur 1. Im Folgenden wird daher lediglich auf die Unterschiede der verschiedenen Ausführungsformen eingegangen.

Wie in der Perspektivansicht der **Figur 8** und der Querschnittsansicht senkrecht zur Längsachse des Führungsbolzens 20 der **Figur 9** besonders gut zu erkennen ist, weist das Kopfteil 11 in dieser Ausführungsform oben und unten jeweils zwei Aussparungen 23 auf, in die die Führungsbolzen 20 von darüber beziehungsweise darunter befindlichen Lamellen jeweils seitlich versetzt positioniert werden können. Diese Ausführungsform wird verwendet, wenn in der Führungsschiene 1 zwei Sammelschienen beziehungsweise Flachstangen 4 vorhanden sind, siehe Figur 10.

In der **Figur 10** ist eine schematische Querschnittsansicht eines Einsatzes 2 für eine hier nicht gezeigte Führungsschiene mit zwei Führungsbolzen 20 gemäß der Figur 6 zur Stromabführung gezeigt. Auf der der Längsöffnung 3 gegenüberliegenden Seite des Einsatzes 3 sind zwei parallel und beanstandet zueinander angeordnete Sammelschienen 4.1, 4.2 in Form von Flachstangen angeordnet. Zwischen den beiden Flachstangen bildet der Kunststoffeinsatz 2 einen Vorsprung 5 zur Isolation der beiden Flachstangen aus.

Der Federkontaktstift 24 des Führungsbolzens 20 einer oberen Lamelle kontaktiert die eine Flachstange, während der Führungsbolzen 20 einer unteren Lamelle mit dem Federkontaktstift 24 die andere Flachstange kontaktiert.

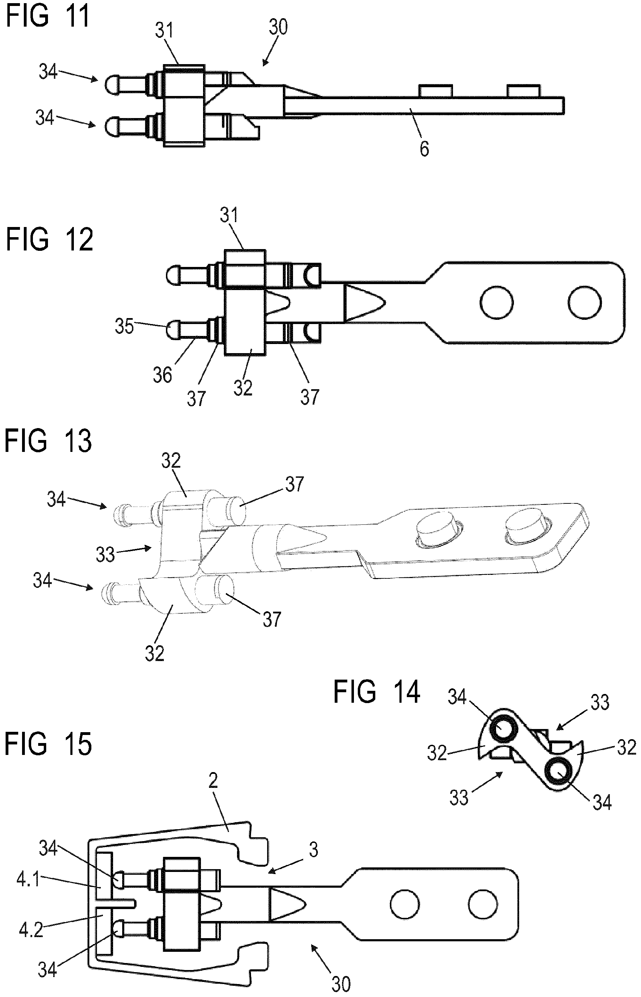

In der **Figur 11** ist noch eine schematische Querschnittsansicht entlang der Längsachse eines Führungsbolzens 30 in einer dritten Ausführungsform und in der **Figur 12** eine schematische Draufsicht gezeigt. Im Folgenden wird wieder lediglich auf die Unterschiede zu den bisherigen Ausführungsformen eingegangen.

Der Führungsbolzen 30 weist in dieser Ausführungsform zwei Federkontaktstifte 34 auf, die jeweils schräg versetzt von einer Ebene durch die Längsachse der Lamelle von dem Kopfteil 31 ragen. Das Kopfteil 31 weist eine S-ähnliche Form auf, wobei von jedem S-Flügel 32 der Kolben 36 und Kolbenkopf 35 eines Federkontaktstiftes 34 nach vorne ragt. Aufgrund der schräg zur Längsachse versetzten Anordnung der Federkontaktstifte 34 sind deren Hülsen 37 nicht in das Kopfteil 31 integriert, sondern ragen aus dessen anderer Seite aus diesem hervor, siehe vor allem **Figur 13** und **Figur 14****.**

Beim Stapeln der Lamellen im hochgezogenen Zustand sind jeweils die S-Flügel 32 in den bogenförmigen Aussparungen 33 und umgekehrt positioniert

In der **Figur 15** ist eine schematische Querschnittsansicht eines Einsatzes 2 für eine hier nicht gezeigte Führungsschiene 1 mit zwei Führungsbolzen 30 gemäß der Figur 11 zur Stromabführung gezeigt.

Für diese Ausführungsform sind ebenfalls zwei parallel und beanstandet zueinander angeordnete Sammelschienen 4.1, 4.2 in Form von Flachstangen ausgebildet mit einem aus dem Kunststoffeinsatz 2 gebildeten Vorsprung 5 zur Isolation.

Die beiden Federkontaktstifte 34 des einen Führungsbolzens 30 kontaktieren jeweils eine der beiden Flachstangen 4.

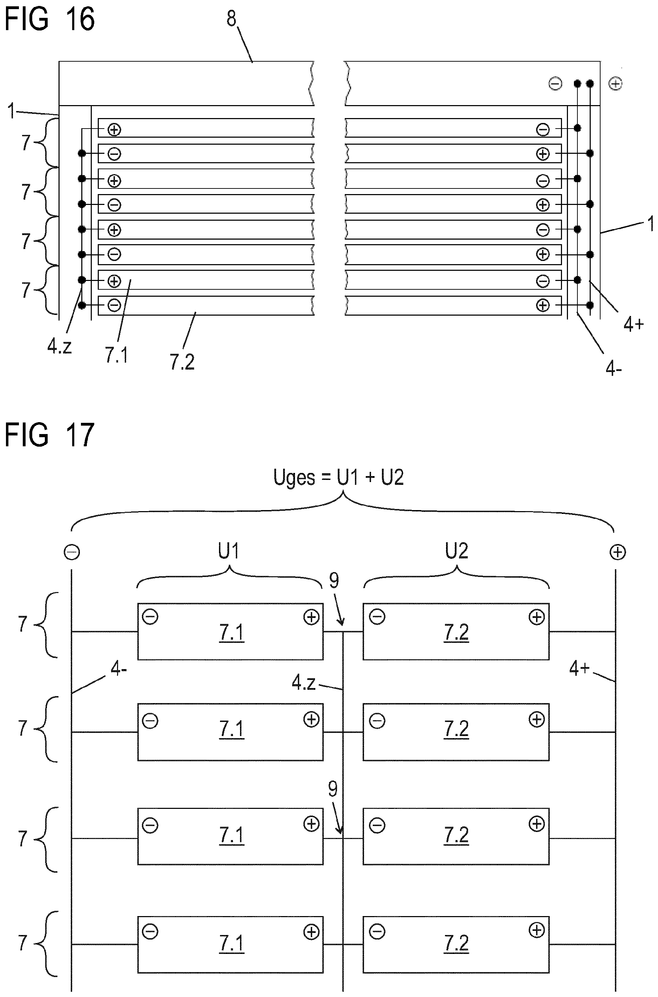

Die **Figur 16** zeigt eine erfindungsgemäße Ausführungsform des oberen Teils eines Raffstores mit einem Lamellenkasten 8 und einem Behang, dessen Lamellen 7.1 und 7.2 mit Photovoltaikelementen versehen sind, die satzweise in Reihenschaltung untereinander verbunden sind und jeweils einen Lamellensatz 7 bilden. Hierbei werden Photovoltaikelemente der Lamellen satzweise mit den Sammelschienen 4+ und 4- zur Stromabfuhr verbunden, wobei je Satz eine Verbindung der Photovoltaikelemente zur Sammelschiene 4.z so hergestellt ist, dass insgesamt je Lamellensatz 7 eine serielle Verbindung zwischen den Photovoltaikelementen der jeweils zwei Lamellen 7.1 und 7.2 entsteht und damit die mit den Photovoltaikelementen erzeugte Spannung U1 und U2 zu einer Gesamtspannung Uges addiert und im Idealfalle verdoppelt wird. Wie aus der Figur 16 ersichtlich ist, verläuft dabei einseitig die Sammelschiene für das Zwischenpotential 4z links in der einen Führungsschiene 1, während die beiden Stromabfuhrschienen 4+ und 4-in der rechten Führungsschiene 1 verlaufen.

Zur übersichtlicheren Darstellung ist die schematische elektrische Schaltung der auf den Lamellen 7.1 und 7.1 angebrachten Photovoltaikelemente aus der Figur 16 nochmals in der **Figur 17** dargestellt. Hierbei ist links die negative oder auf Erde liegende Sammelschiene 4- angeordnet, von der Ableitungen auf die jeweils erste Lamelle 7.1 eines Lamellensatzes 7 abgehen. Die erste und zweite Lamelle 7.1 und 7.2 sind gemeinsam und mit umgekehrter Polarität mit der Sammelschiene 4.z verbunden, wobei dort ein gemeinsames Zwischenpotential der Spannung U1 zwischen den jeweils ersten und den zweiten Lamellen 7.1 und 7.2 anliegt. Die jeweils zweiten Lamellen 7.2 sind dann mit der positiven Seite ihrer Photovoltaikelemente mit deren Spannung U2 mit der Sammelschiene 4+ verbunden, wobei zwischen den Sammelschienen 4- und 4+ eine Gesamtspannung Uges = U1 + U2 erzeugt wird. Die beiden Sammelschienen 4+ und 4-dienen dabei zur Stromabfuhr mit dem Potential der Gesamtspannung Uges und vereinen die gesamte Stromleistung des erfindungsgemäßen Raffstores.

Der erfindungsgemäße Raffstore besteht also aus einer Vielzahl von in Parallelschaltung verbundener Lamellensätze 7 aus seriell verbundenen Lamellen 7.1 und 7.2, wobei das Zwischenpotential zwischen allen ersten Lamellen 7.1 und allen zweiten Lamellen 7.2 untereinander verbunden ist.

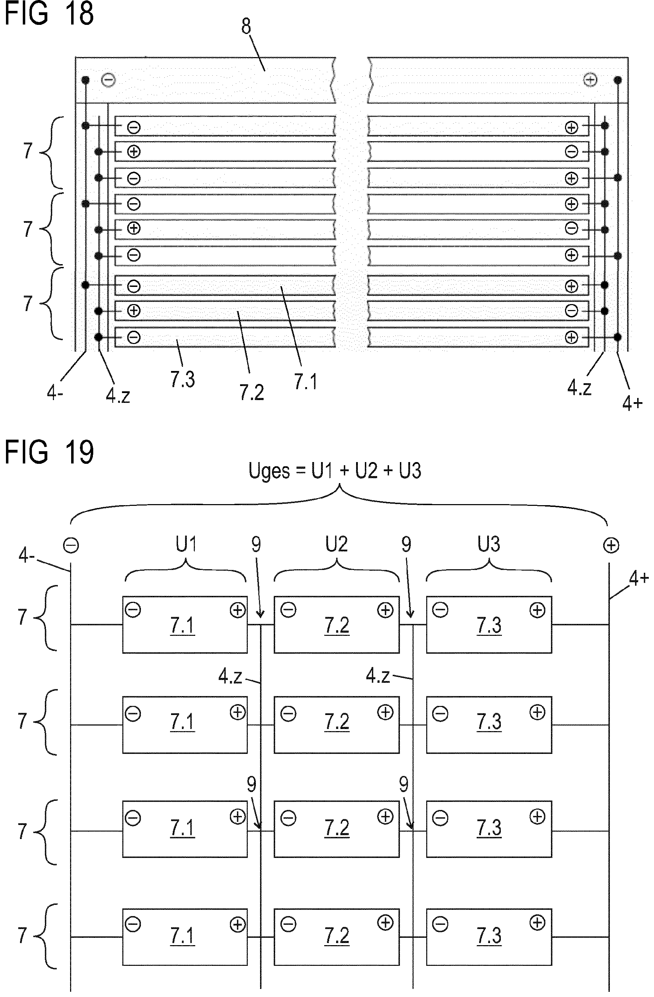

Eine andere Ausführungsform des erfindungsgemäßen Raffstores sieht vor, dass jeweils drei Lamellen 7.1, 7.2 und 7.3 eines Lamellensatzes 7 seriell verschaltet und insgesamt die Lamellensätze 7 des gesamten Raffstores parallel und auch die ersten, zweiten und dritten Lamellen 7.1, 7.2 und 7.3 untereinander parallel verbunden werden. Eine solche Ausführung ist beispielhaft in der **Figur 18** dargestellt. Diese zeigt den oberen Teil eines Raffstores mit einem Lamellenkasten 8 mit seitlich angeordneten erfindungsgemäß ausgestalteten Führungsschienen 1 und drei Lamellensätzen 7. Jeder Lamellensatz 7 enthält eine erste, zweite und dritte Lamelle 7.1, 7.2, und 7.3 mit jeweils darauf angeordnetem Photovoltaikelement. Rechts und links in den Führungsschienen ist jeweils eine Sammelschiene 4+ und 4- angeordnet, welche einerseits mit einem externen Stromanschluss verbunden ist und andererseits die Lamellensätze 7 elektrisch verbindet. Zusätzlich ist in den seitlichen Führungsschienen 1 jeweils eine Sammelschiene 4.z angeordnet, welche die einzelnen Lamellen 7.1 mit 7.2 und 7.2 mit 7.3 seriell und gleichzeitig alle ersten Lamellen 7.1, alle zweiten Lamellen 7.2 und alle dritten Lamellen 7.3 jeweils parallel verbindet.

Eine schematische Darstellung dieser elektrischen Schaltung aus der Figur 18 ist in der **Figur 19** gezeigt. Dort liegen vier Lamellensätze 7 vor, welche jeweils aus den drei Lamellen 7.1 bis 7.3 bestehen. Diese drei Lamellen 7.1, 7.2 und 7.3 sind je Lamellensatz 7 seriell untereinander verbunden. Gleichzeitig sind die Lamellensätze jeweils parallel über Sammelschienen 4- und 4+ verbunden. Außerdem besteht auch hier eine parallele Verbindung an den gleichen Zwischenpotentialen der einzelnen Lamellen 7.1 und 7.2 über die beiden Sammelschienen 4.z, wobei diese Sammelschienen 4.z jeweils nach außen isoliert ausgebildet sind. Auf diese Weise kann die erreichte Betriebsspannung Uges auf die Summe der Einzelspannungen U1+U2+U3 der ersten, zweiten und dritten Lamelle 7.1, 7.2 und 7.3 erhöht werden, um Übertragungsverluste möglichst gering zu halten. Gleichzeitig wird die Stromleistung der Lamellensätze 7 entsprechend deren Anzahl im Raffstore aufsummiert.

Insgesamt wird mit der Erfindung also ein Stromabführungssystem mit Führungsbolzen und mindestens einer seitlichen Führungsschiene für einen Raffstore mit einer Vielzahl von Lamellen, welche jeweils mittels der Führungsbolzen in den seitlichen Führungsschienen beweglich lagerbar sind und jeweils mindestens ein Photovoltaikelement zur Stromerzeugung aufweisen, welches mit den Führungsbolzen der jeweiligen Lamelle elektrisch verbindbar ist, vorgeschlagen, wobei in den beiden Führungsschienen insgesamt mindestens zwei elektrische Sammelschienen vorliegen, sodass ein elektrischer Kontakt durch mindestens ein Kontaktmittel mit den Photovoltaikelementen der Lamellen vorliegt, um den erzeugten Strom abzuführen. Weiter wird ein Raffstore mit einer Vielzahl von Lamellen mit jeweils mindestens einem Photovoltaikelement zur Stromerzeugung vorgeschlagen, wobei zur Abführung des erzeugten Stromes ein erfindungsgemäßes Stromabführungssystem vorliegt.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

### Bezugszeichenliste

1 Führungsschiene
2 Einsatz
3 Längsöffnung
4 Sammelschiene
4+ positive Sammelschiene
4- negative Sammelschiene
4.z Sammelschiene für Zwischenpotential
5 Isolator
6 Zwischenstück zur Befestigung der Lamelle
7 Lamelle mit Photovoltaikelement
7.1 erste Lamelle mit Photovoltaikelement eines seriellen Lamellensatzes
7.2 zweite Lamelle mit Photovoltaikelement eines seriellen Lamellensatzes
7.3 dritte Lamelle mit Photovoltaikelement eines seriellen Lamellensatzes
8 Lamellenkasten
9+ positive Sammelschiene
9- negative Sammelschiene
10, 20, 30 Führungsbolzen
11, 21, 31 Kopfteil
12, 22, 32 Flügel
13, 23, 33 Aussparungen
14, 24, 34 Federkontaktstift
15, 25, 35 Kolbenkopf
16, 26, 36 Kolben
17, 27, 37 Hülse

## Patentansprüche

1. Stromabführungssystem mit Führungsbolzen (10, 20, 30) und mindestens einer seitlichen Führungsschiene (1) für eine Beschattungseinrichtung mit einer Vielzahl von Lamellen (7), insbesondere für einen Raffstore oder für eine Jalousie, wobei die Lamellen (7) jeweils mittels der Führungsbolzen (10, 20, 30) in der mindestens einen seitlichen Führungsschiene (1) beweglich lagerbar sind, wobei die Beschattungseinrichtung Photovoltaikelemente zur Stromerzeugung aufweist, wobei die Photovoltaikelemente mit den Führungsbolzen (10, 20, 30) der jeweiligen Lamelle (7) elektrisch verbindbar sind, wobei in der mindestens einen Führungsschiene (1) insgesamt mindestens zwei elektrische Sammelschienen (4) vorliegen, sodass ein elektrischer Kontakt durch mindestens ein Kontaktmittel mit den Photovoltaikelementen der Lamellen (7) herstellbar ist, um den erzeugten Strom abzuführen,
**dadurch gekennzeichnet, dass**
1.1. die Führungsbolzen (10, 20, 30) jeweils ein scheibenartiges Kopfteil (11, 21, 31) aufweisen, von welchem das mindestens eine Kontaktmittel in Längsrichtung der Lamelle absteht, wobei das Kopfteil (11, 21, 31) zumindest an seiner Oberseite eine Aussparung (13, 23, 33) aufweist, um im hochgezogenen Zustand der Beschattungseinrichtung ein platzsparendes Stapeln der Lamellen zu ermöglichen, und
1.2. die Kontaktmittel als Federkontaktstift (14, 24, 34) ausgebildet sind, wobei der Federkontaktstift (14, 24, 34) zumindest einen Kolben (16, 26, 36), eine Hülse (17, 27, 37) und eine innenliegende Feder aufweist, und die Hülse (17, 27, 37) in den Führungsbolzen (10, 20, 30) integriert ist, sodass der Führungsbolzen (10, 20, 30) als Hülse und Führung für den Kolben (16, 26, 36) dient.

2. Stromabführungssystem gemäß dem voranstehenden Patentanspruch 1,
**dadurch gekennzeichnet, dass** zwei seitliche Führungsschienen (1) ausgebildet sind und in den beiden Führungsschienen (1) insgesamt mindestens zwei elektrische Sammelschienen (4) vorliegen.

3. Stromabführungssystem gemäß einem der voranstehenden Patentansprüche 1 bis 2, **dadurch gekennzeichnet, dass** ein Führungsbolzen (10, 20, 30) mindestens ein Kontaktmittel (14, 24, 34) aufweist, welches den elektrischen Kontakt zur Sammelschiene (4) ausbildet.

4. Stromabführungssystem gemäß einem der voranstehenden Patentansprüche 1 bis 2, **dadurch gekennzeichnet, dass** ein Führungsbolzen (10, 20, 30) genau ein Kontaktmittel (14, 24, 34) aufweist.

5. Stromabführungssystem gemäß dem voranstehenden Patentanspruch 4,
**dadurch gekennzeichnet, dass** die jeweils einen Kontaktmittel (14, 24, 34) benachbarter Lamellen an den Führungsbolzen (10, 20, 30) senkrecht untereinander angeordnet sind.

6. Stromabführungssystem gemäß dem voranstehenden Patentanspruch 4,
**dadurch gekennzeichnet, dass** die jeweils einen Kontaktmittel (14, 24, 34) benachbarter Lamellen an den Führungsbolzen (10, 20, 30) seitlich versetzt untereinander angeordnet sind

7. Stromabführungssystem gemäß einem der voranstehenden Patentansprüche 1 bis 2, **dadurch gekennzeichnet, dass** ein Führungsbolzen (10, 20, 30) zwei Kontaktmittel (14, 24, 34) aufweist.

8. Stromabführungssystem gemäß dem voranstehenden Patentanspruch 7,
**dadurch gekennzeichnet, dass** die zwei Kontaktmittel (14, 24, 34) an einem Führungsbolzen (10, 20, 30) relativ zu einer durch die Oberfläche der Lamellen verlaufenden Ebene auf unterschiedlicher Höhe seitlich versetzt angeordnet sind.

9. Stromabführungssystem gemäß einem der voranstehenden Patentansprüche 1 bis 8, **dadurch gekennzeichnet, dass** in die Längsöffnungen (3) der mindestens einen Führungsschiene (1) zumindest abschnittsweise Gummidichtungen und/oder Bürstendichtungen eingesetzt sind.

10. Stromabführungssystem gemäß einem der voranstehenden Patentansprüche 1 bis 9, **dadurch gekennzeichnet, dass** zwischen den Führungsbolzen (10, 20, 30) benachbarter Lamellen jeweils ein Stoffeinsatz angeordnet ist, welcher im heruntergelassenen Zustand der Lamellen die Längsöffnungen (3) der mindestens einen Führungsschiene (1) zumindest teilweise abdeckt.

11. Stromabführungssystem gemäß einem der voranstehenden Patentansprüche 1 bis 10, **dadurch gekennzeichnet, dass** mehrfach jeweils mindestens zwei Lamellen (7.1, 7.2, 7.3) untereinander seriell elektrisch zu jeweils einem Lamellensatz (7) verbunden sind, wobei die Verbindungsstellen (9) zwischen den Lamellen (7.1 mit 7.2 und 7.2 mit 7.3) untereinander parallel über jeweils eine Sammelschiene (4.z) elektrisch gekoppelt sind.

12. Stromabführungssystem gemäß dem voranstehenden Patentanspruch 11,
**dadurch gekennzeichnet, dass** je Lamellensatz (7) genau zwei seriell geschaltete Lamellen (7.1, 7.2) vorliegen, wobei:
- die potentialgleichen Verbindungsstellen (9) zwischen der jeweils ersten Lamelle (7.1) und der zweiten Lamelle (7.2) über eine Sammelschiene (4.z) auf einer ersten Seite der Beschattungseinrichtung elektrisch verbunden sind, und
- jeder Lamellensatz (7) an die positiven und negativen Sammelschienen (4+, 4-) auf der zur ersten Seite gegenüberliegenden zweiten Seite der Beschattungseinrichtung elektrisch angeschlossen sind, wobei die Polarität (+, -) der Lamellen in der Beschattungseinrichtung von oben nach unten alternierend ausgeführt ist.

13. Stromabführungssystem gemäß dem voranstehenden Patentanspruch 11,
**dadurch gekennzeichnet, dass** je Lamellensatz (7) genau drei seriell geschaltete Lamellen (7.1, 7.2, 7.3) vorliegen, wobei:
- die potentialgleichen Verbindungsstellen (9) zwischen der jeweils ersten Lamelle (7.1) und der zweiten Lamelle (7.2) über eine erste Sammelschiene (4.z) auf einer ersten Seite der Beschattungseinrichtung elektrisch verbunden sind,
- die potentialgleichen Verbindungsstellen (9) zwischen der jeweils zweiten Lamelle (7.2) und der dritten Lamelle (7.3) über eine zweite Sammelschiene (4.z) auf einer zweiten - der ersten Seite gegenüberliegenden - Seite der Beschattungseinrichtung elektrisch verbunden sind,
- jeder Lamellensatz (7) an eine positive Sammelschiene (4+) und eine negative Sammelschiene (4-) auf jeweils einer Seite der Beschattungseinrichtung elektrisch angeschlossen ist.

14. Beschattungseinrichtung, insbesondere ein Raffstore oder eine Jalousie, zumindest aufweisend einen Behang mit einer Vielzahl von Lamellen, welche jeweils mittels Führungsbolzen (10, 20, 30) in mindestens einer seitlichen Führungsschiene (1) beweglich gelagert sind und jeweils mindestens ein Photovoltaikelement zur Stromerzeugung aufweisen, **dadurch gekennzeichnet, dass**
zur Abführung des erzeugten Stromes ein Stromabführungssystem gemäß einem der voranstehenden Patentansprüche 1 bis 13 vorliegt.

15. Beschattungseinrichtung gemäß dem voranstehenden Patentanspruch 14, **dadurch gekennzeichnet, dass** der Behang zumindest ein erstes Lamellenpaket und ein zweites Lamellenpaket umfasst, wobei die Lamellenpakete unterschiedlich um die jeweiligen Längsachsen der Lamellen gekippt werden können.

## Claims

1. Current discharge system having guide pins (10, 20, 30) and at least one lateral guide rail (1) for a shading device having a multiplicity of slats (7), in particular for a Venetian blind or for a slatted blind, wherein the slats (7) can each be movably mounted in the at least one lateral guide rail (1) by means of the guide pins (10, 20, 30), wherein the shading device has photovoltaic elements for generating power, wherein the photovoltaic elements are electrically connectable to the guide pins (10, 20, 30) of the respective slat (7), wherein
a total of at least two electrical busbars (4) are present in the at least one guide rail (1), with the result that electrical contact can be established by at least one contact means with the photovoltaic elements of the slats (7) in order to discharge the generated current,
**characterized in that**
1.1. the guide pins (10, 20, 30) each have a disc-like head part (11, 21, 31), from which the at least one contact means protrudes in the longitudinal direction of the slat, wherein the head part (11, 21, 31) has a cut-out (13, 23, 33) at least on its upper side, in order to enable space-saving stacking of the slats in the raised state of the shading device, and
**1.2.** the contact means are in the form of a spring contact pin (14, 24, 34), wherein the spring contact pin (14, 24, 34) has at least one piston (16, 26, 36), a sleeve (17, 27, 37) and an inner spring, and the sleeve (17, 27, 37) is integrated into the guide pin (10, 20, 30), with the result that the guide pin (10, 20, 30) serves as a sleeve and guide for the piston (16, 26, 36).

2. Current discharge system according to the preceding Patent Claim 1, **characterized in that** two lateral guide rails (1) are formed and a total of at least two electrical busbars (4) are present in the two guide rails (1).

3. Current discharge system according to either of the preceding Patent Claims 1 to 2, **characterized in that** a guide pin (10, 20, 30) has at least one contact means (14, 24, 34) which forms the electrical contact with the busbar (4).

4. Current discharge system according to either of the preceding Patent Claims 1 to 2, **characterized in that** a guide pin (10, 20, 30) has exactly one contact means (14, 24, 34).

5. Current discharge system according to the preceding Patent Claim 4, **characterized in that** the in each case one contact means (14, 24, 34) of adjacent slats are arranged perpendicularly with respect to one another on the guide pins (10, 20, 30).

6. Current discharge system according to the preceding Patent Claim 4, **characterized in that** the in each case one contact means (14, 24, 34) of adjacent slats are arranged laterally offset from one another on the guide pins (10, 20, 30).

7. Current discharge system according to either of the preceding Patent Claims 1 to 2, **characterized in that** a guide pin (10, 20, 30) has two contact means (14, 24, 34).

8. Current discharge system according to the preceding Patent Claim 7, **characterized in that** the two contact means (14, 24, 34) are arranged on a guide pin (10, 20, 30) laterally offset at different heights relative to a plane running through the surface of the slats.

9. Current discharge system according to one of the preceding Patent Claims 1 to 8, **characterized in that** rubber seals and/or brush seals are inserted at least in sections into the longitudinal openings (3) of the at least one guide rail (1).

10. Current discharge system according to one of the preceding Patent Claims 1 to 9, **characterized in that** a material insert is arranged in each case between the guide pins (10, 20, 30) of adjacent slats, the said material insert at least partially covering the longitudinal openings (3) of the at least one guide rail (1) in the lowered state of the slats.

11. Current discharge system according to one of the preceding Patent Claims 1 to 10, **characterized in that** in each case at least two slats (7.1, 7.2, 7.3) are repeatedly electrically connected to one another in series to form in each case one slat set (7), wherein the connecting points (9) between the slats (7.1 with 7.2 and 7.2 with 7.3) are electrically coupled to one another in parallel via in each case one busbar (4.z).

12. Current discharge system according to the preceding Patent Claim 11, **characterized in that** exactly two serially connected slats (7.1, 7.2) are present per slat set (7), wherein:
- the equal-potential connecting points (9) between the respective first slat (7.1) and the second slat (7.2) are electrically connected via a busbar (4.z) on a first side of the shading device, and
- each slat set (7) is electrically connected to the positive and negative busbars (4+, 4-) on the second side of the shading device lying opposite the first side, wherein the polarity (+, -) of the slats in the shading device is configured in an alternating manner from top to bottom.

13. Current discharge system according to the preceding Patent Claim 11, **characterized in that** exactly three serially connected slats (7.1, 7.2, 7.3) are present per slat set (7), wherein:
- the equal-potential connecting points (9) between the respective first slat (7.1) and the second slat (7.2) are electrically connected via a first busbar (4.z) on a first side of the shading device,
- the equal-potential connecting points (9) between the respective second slat (7.2) and the third slat (7.3) are electrically connected via a second busbar (4.z) on a second side of the shading device lying opposite the first side,
- each slat set (7) is electrically connected to a positive busbar (4+) and a negative busbar (4-) on in each case one side of the shading device.

14. Shading device, in particular a Venetian blind or a slatted blind, at least having a hanging with a multiplicity of slats which are each movably mounted in at least one lateral guide rail (1) by means of guide pins (10, 20, 30) and each have at least one photovoltaic element for generating power,
**characterized in that**,
in order to discharge the generated current, a current discharge system according to one of the preceding Patent Claims 1 to 13 is present.

15. Shading device according to the preceding Patent Claim 14, **characterized in that** the hanging comprises at least a first slat pack and a second slat pack, wherein the slat packs can be tilted differently about the respective longitudinal axes of the slats.

## Revendications

1. Système d'évacuation de courant avec des boulons de guidage (10, 20, 30) et au moins un rail de guidage latéral (1) pour un appareil d'ombrage avec une pluralité de lamelles (7), notamment pour un store extérieur à lamelles ou pour un store vénitien, les lamelles (7) pouvant respectivement être montées de manière mobile dans l'au moins un rail de guidage latéral (1) au moyen des boulons de guidage (10, 20, 30), l'appareil d'ombrage présentant des éléments photovoltaïques pour la production de courant, les éléments photovoltaïques pouvant être reliés électriquement aux boulons de guidage (10, 20, 30) de la lamelle respective (7),
au total au moins deux barres omnibus électriques (4) étant présentes dans l'au moins un rail de guidage (1), de telle sorte qu'un contact électrique peut être établi par au moins un moyen de contact avec les éléments photovoltaïques des lamelles (7) afin d'évacuer le courant produit,
**caractérisé en ce que**
1.1. les boulons de guidage (10, 20, 30) présentent chacun une partie de tête (11, 21, 31) en forme de disque, à partir de laquelle l'au moins un moyen de contact fait saillie dans la direction longitudinale de la lamelle, la partie de tête (11, 21, 31) présentant au moins sur son côté supérieur un évidement (13, 23, 33) pour permettre un empilement peu encombrant des lamelles à l'état relevé de l'appareil d'ombrage, et
1.2. les moyens de contact sont réalisés sous forme de broche de contact à ressort (14, 24, 34), la broche de contact à ressort (14, 24, 34) présentant au moins un piston (16, 26, 36), une douille (17, 27, 37) et un ressort intérieur, et la douille (17, 27, 37) étant intégrée dans le boulon de guidage (10, 20, 30), de telle sorte que le boulon de guidage (10, 20, 30) sert de douille et de guidage pour le piston (16, 26, 36).

2. Système d'évacuation de courant selon la revendication 1 précédente, **caractérisé en ce que** deux rails de guidage latéraux (1) sont réalisés et au total au moins deux barres omnibus électriques (4) sont présentes dans les deux rails de guidage (1).

3. Système d'évacuation de courant selon l'une quelconque des revendications 1 à 2 précédentes, **caractérisé en ce qu'**un boulon de guidage (10, 20, 30) présente au moins un moyen de contact (14, 24, 34) qui réalise le contact électrique avec la barre omnibus (4).

4. Système d'évacuation de courant selon l'une quelconque des revendications 1 à 2 précédentes, **caractérisé en ce qu'**un boulon de guidage (10, 20, 30) présente exactement un moyen de contact (14, 24, 34).

5. Système d'évacuation de courant selon la revendication 4 précédente, **caractérisé en ce que** les moyens de contact respectifs (14, 24, 34) de lamelles voisines sur les boulons de guidage (10, 20, 30) sont agencés perpendiculairement les uns aux autres.

6. Système d'évacuation de courant selon la revendication 4 précédente, **caractérisé en ce que** les moyens de contact respectifs (14, 24, 34) de lamelles voisines sont agencés sur les boulons de guidage (10, 20, 30) de manière décalée latéralement les uns par rapport aux autres.

7. Système d'évacuation de courant selon l'une quelconque des revendications 1 à 2 précédentes, **caractérisé en ce qu'**un boulon de guidage (10, 20, 30) présente deux moyens de contact (14, 24, 34).

8. Système d'évacuation de courant selon la revendication 7 précédente, **caractérisé en ce que** les deux moyens de contact (14, 24, 34) sur un boulon de guidage (10, 20, 30) sont agencés de manière décalée latéralement à des hauteurs différentes par rapport à un plan s'étendant à travers la surface des lamelles.

9. Système d'évacuation de courant selon l'une quelconque des revendications 1 à 8 précédentes, **caractérisé en ce que** des joints en caoutchouc et/ou des joints à brosse sont insérés au moins par sections dans les ouvertures longitudinales (3) de l'au moins un rail de guidage (1).

10. Système d'évacuation de courant selon l'une quelconque des revendications 1 à 9 précédentes, **caractérisé en ce qu'**entre les boulons de guidage (10, 20, 30) de lamelles voisines est agencé respectivement un insert en tissu qui, à l'état abaissés des lamelles, recouvre au moins partiellement les ouvertures longitudinales (3) de l'au moins un rail de guidage (1) .

11. Système d'évacuation de courant selon l'une quelconque des revendications 1 à 10 précédentes, **caractérisé en ce que** plusieurs fois au moins deux lamelles (7.1, 7.2, 7.3) sont reliées électriquement en série entre elles respectivement en un jeu de lamelles (7), les points de liaison (9) entre les lamelles (7.1 avec 7.2 et 7.2 avec 7.3) étant couplés électriquement entre eux en parallèle par l'intermédiaire respectivement d'une barre omnibus (4.z).

12. Système d'évacuation de courant selon la revendication 11 précédente, **caractérisé en ce que** pour chaque jeu de lamelles (7), exactement deux lamelles (7.1, 7.2) montées en série sont présentes :
- les points de liaison (9) de même potentiel entre la première lamelle (7.1) respective et la deuxième lamelle (7.2) étant reliés électriquement par une barre omnibus (4.z) sur un premier côté de l'appareil d'ombrage, et
- chaque jeu de lamelles (7) étant raccordé électriquement aux barres omnibus positives et négatives (4+, 4-) sur le deuxième côté de l'appareil d'ombrage opposé au premier côté, la polarité (+, -) des lamelles dans l'appareil d'ombrage étant conçue en alternance de haut en bas.

13. Système d'évacuation de courant selon la revendication 11 précédente, **caractérisé en ce que** pour chaque jeu de lamelles (7), exactement trois lamelles (7.1, 7.2, 7.3) montées en série sont présentes :
- les points de liaison (9) de même potentiel entre la première lamelle (7.1) respective et la deuxième lamelle (7.2) étant reliés électriquement par une première barre omnibus (4.z) sur un premier côté de l'appareil d'ombrage,
- les points de liaison (9) de même potentiel entre la deuxième lamelle (7.2) respective et la troisième lamelle (7.3) étant reliés électriquement par une deuxième barre omnibus (4.z) sur un deuxième côté - opposé au premier côté - de l'appareil d'ombrage,
- chaque jeu de lamelles (7) étant raccordé électriquement à une barre omnibus positive (4+) et à une barre omnibus négative (4-) sur un côté respectif de l'appareil d'ombrage.

14. Appareil d'ombrage, notamment store extérieur à lamelles ou store vénitien, présentant au moins un tablier avec une pluralité de lamelles, qui sont respectivement montées de manière mobile dans au moins un rail de guidage latéral (1) au moyen de boulons de guidage (10, 20, 30) et présentent respectivement au moins un élément photovoltaïque pour la production de courant, **caractérisé en ce que**
un système d'évacuation de courant selon l'une quelconque des revendications 1 à 13 précédentes est présent pour évacuer le courant produit.

15. Appareil d'ombrage selon la revendication 14 précédente, **caractérisé en ce que** le tablier comprend au moins un premier paquet de lamelles et un deuxième paquet de lamelles, les paquets de lamelles pouvant être inclinés différemment autour des axes longitudinaux respectifs des lamelles.
